# FASCICULE DE BREVET EUROPEEN

(11) **EP 0 756 322 B1**
(45) Date de publication et mention de la délivrance du brevet: **06.03.2002**
(21) Numéro de dépôt: 96401615.8
(22) Date de dépôt: 19.07.1996
(51) Int. Cl.: H01L 23/367, H01L 23/522

(54) **Composant semi-conducteur avec dissipateur thermique intégré**
Halbleiter mit integriertem Kühler
Semiconductor device with integrated heat sink

(30) Priorité: 25.07.1995 FR 9508994
(43) Date de publication de la demande: 29.01.1997
(73) Titulaire: Thales, 75008 Paris (FR)
(72) Inventeur: Delage, Sylvain, Thomson-CSF, SCPI, 92402 Courbevoie Cedex (FR); Cassette, Simone, Thomson-CSF, SCPI, 92402 Courbevoie Cedex (FR); Blanck, Hervé, Thomson-CSF, SCPI, 92402 Courbevoie Cedex (FR); Chartier, Eric, Thomson-CSF, SCPI, 92402 Courbevoie Cedex (FR)

(56) Documents cités:
- EP-A- 0 446 125
- WO-A-94/15361
- US-A- 3 956 820
- US-A- 5 034 799
- PATENT ABSTRACTS OF JAPAN vol. 950, no. 004 & JP-A-07 111272 (MURATA MFG CO LTD), 25 Avril 1995,

## Description

Le domaine de l'invention est celui des composants semiconducteurs de puissance et notamment celui des transistors bipolaires présentant un grand intérêt dans des applications hyperfréquences.

L'invention concerne l'introduction d'un dissipateur thermique au niveau du composant de puissance, permettant ainsi d'augmenter pour une température de fonctionnement donnée, la puissance disponible par unité de surface de semiconducteur.

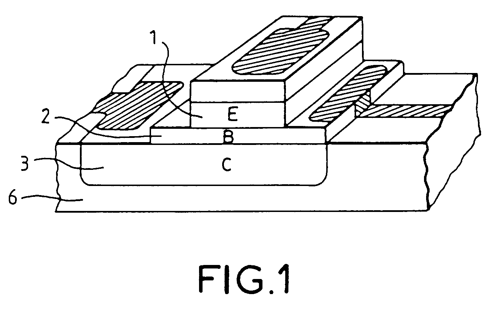

Dans le cadre des transistors de puissance et plus particulièrement dans le cadre de transistors bipolaires à hétérojonction HBT, d'une manière générale, les composants sont réalisés en matériaux du groupe III-V et résultent d'une technologie verticale. Ils présentent au moins une structure de "mésa" émetteur, depuis laquelle les charges s'écoulent perpendiculairement au substrat. La figure 1 illustre une configuration classique de transistor bipolaire HBT. Un substrat 6 comprend un collecteur 3 qui peut être enterré dans le substrat 6 sur lequel repose une couche de base 2, qui elle-même supporte une couche émetteur 1 et une couche de prise de contact.

Le courant électrique traverse ainsi les couches E, B, C d'émetteur, base et collecteur perpendiculairement à leur plan. De tels transistors sont capables de commander des densités de courant extrêmement importantes atteignant 2.10⁵ A.cm⁻² et de très fortes tensions.

Ceci entraîne d'importants problèmes de dissipation thermique puisque le collecteur du transistor soumis à de très fortes tensions est soumis à un fort échauffement, la chaleur dégagée étant d'autant plus difficile à évacuer que la structure est verticale, en mésa.

Dans le cadre de composant de puissance, il a déjà été proposé d'utiliser un pont métallique, comme dissipateur thermique, dont les jambes reposent directement sur les métallisations du composant comme décrit dans la demande de brevet 0 446 125 A1.

L'invention propose d'utiliser également ce type de dissipateur thermique mais appliqué à des composants à double mesa, recouverts d'une couche de passivation et présentant une structure partiellement aérienne, l'autre partie du dissipateur reposant sur la face avant du composant.

Plus précisément, l'invention a pour objet un dispositif semiconducteur comprenant au moins une région comportant un premier mesa sur une première face du substrat dite face avant et un second mesa formé sur le premier mesa, ladite région étant la source d'un important dégagement de chaleur, les mesas et la face avant étant recouverts d'une couche de passivation, le dispositif comprenant un dissipateur thermique métallique comportant :
- une partie aérienne se présentant sous forme de pont dont les jambes reposent sur la couche située sur l'ensemble du premier et du deuxième mesa, la partie aérienne ayant des parties qui s'étendent au-dessus de régions de la face avant autres que celles constituant le premier et le deuxième mesa sans toucher ces régions ;
- une partie recouvrant des régions de la face avant du substrat, autres que celles constituant le premier et le deuxième mesa, et autres que lesdites régions au-dessus desquelles la partie aérienne a des parties qui s'étendent.

Le dispositif semiconducteur selon l'invention peut comprendre un transistor ou des transistors montés en parallèle, chaque transistor présentant deux mésa successifs à partir du substrat, un premier mésa constitué par la base, un second mésa constitué par l'émetteur, le premier mésa comportant des métallisations de base mB de part et d'autre de l'émetteur, le second mésa comportant une métallisation d'émetteur mE, la partie aérienne PI du dissipateur thermique étant en forme de pont dont les jambes reposent sur la couche CP située sur l'ensemble de la métallisation (mE) du premier mesa et sur les métallisations (mB) du deuxième mesa.

Dans une première variante de l'invention, le contact émetteur CE peut être pris à une extrémité du doigt émetteur.

L'invention a également pour objet un dispositif semiconducteur précédemment décrit dans lequel la couche de passivation CP est ouverte localement au niveau des doigts d'émetteur de manière à assurer un contact électrique CE' homogène au niveau de l'émetteur, mais dont la réalisation technologique est plus délicate que celle du contact CE dans la première variante de l'invention.

Cette variante de l'invention permet de résoudre le problème rencontré dans les dispositifs de puissance et concernant la non homogénéité de courant injecté à une extrémité des émetteurs des transistors élémentaires.

En effet, le courant est naturellement plus important à proximité du point d'alimentation, ceci entraînant une limitation de surface d'un transistor élémentaire, inférieure typiquement à 100 µm² pour ne pas excéder des densités de courant de 10⁶ A.cm⁻².

Le composant semiconducteur selon l'invention peut avantageusement comprendre un substrat dont la face arrière est métallisée pour constituer un plan de masse relié au dissipateur thermique par l'intermédiaire de via-trous réalisés dans le substrat.

L'invention peut avantageusement être appliquée à des transistors bipolaires à hétérojonction de puissance de type GalnP/GaAs épitaxiés sur substrat GaAs.

L'invention sera mieux comprise et d'autres avantages apparaîtront à la lecture de la description qui va suivre donnée à titre non limitatif et grâce aux figures annexées parmi lesquelles :
- la figure 1 illustre une structure de transistor bipolaire à hétérojonction, selon l'art connu, décrit précédemment ;
- la figure 2 montre une vue en coupe d'un doigt élémentaire d'un transistor de puissance, selon une première variante de l'invention ;
- la figure 3 illustre deux transistors mis en parallèle dans un composant selon une première variante de l'invention ;
- la figure 4 illustre deux transistors mis en parallèle dans un composant selon une deuxième variante de l'invention dans lequel les contacts d'émetteur CE' sont pris sur les doigts d'émetteur ;
- la figure 5 montre l'évolution de la résistance thermique en fonction du nombre de doigts que comportent des composants avec dissipateur thermique et sans dissipateur thermique ;
- la figure 6 illustre la résistance thermique d'un doigt élémentaire en fonction du nombre de doigts dans des composants avec dissipateur thermique et sans dissipateur thermique ;
- la figure 7 montre le gain hyperfréquence en fonction de la fréquence pour des composants avec dissipateur thermique et sans dissipateur thermique ;
- la figure 8 illustre un procédé de réalisation d'un dissipateur thermique couplé à des transistors bipolaires.

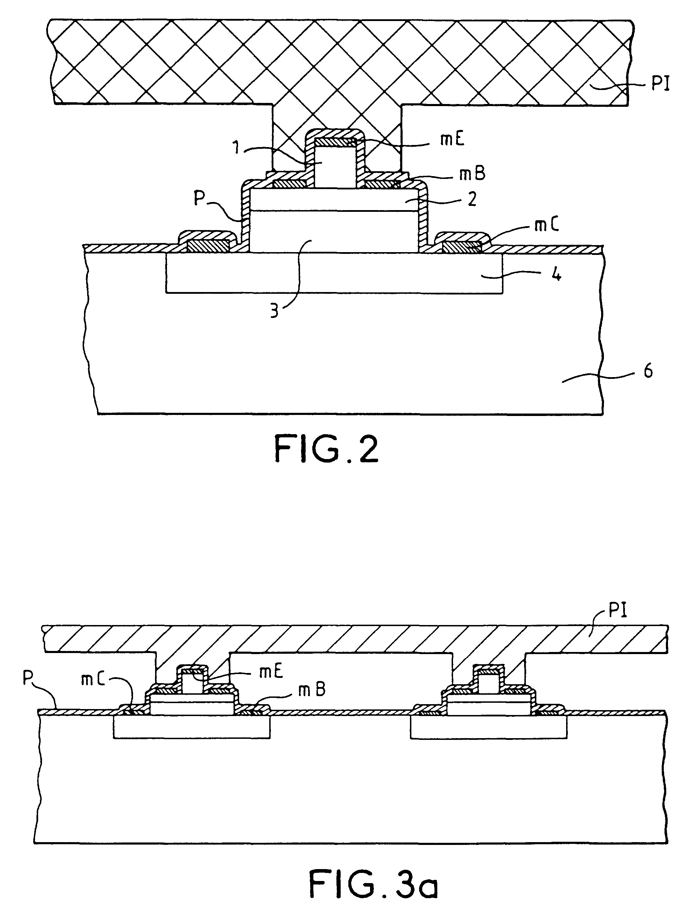

La figure 2 est relative à un exemple de transistor de puissance selon une première variante de l'invention et montre une vue en coupe d'un doigt élémentaire d'un composant HBT. Elle illustre la partie aérienne du dissipateur thermique métallique qui repose sur la couche de passivation CP, au niveau des métallisations de base mB et de la métallisation émetteur mE. Ainsi à partir d'un substrat semiconducteur 6, d'un sous-collecteur enterré 4 dans le substrat, un premier mésa 3 constitue le collecteur de part et d'autre duquel figurent des métallisations mC permettant la prise de contact au niveau du collecteur.

Sur le collecteur, une couche de base 2 est recouverte partiellement d'une couche d'émetteur 1 de part et d'autre de laquelle sont réalisées des métallisations de base mB. L'émetteur est lui aussi recouvert d'une métallisation mE. L'ensemble est protégé grâce à une couche de passivation CP. Les jambes du pont constituant la partie aérienne du dissipateur thermique reposent sur la couche CP au niveau des métallisations mB et mE.

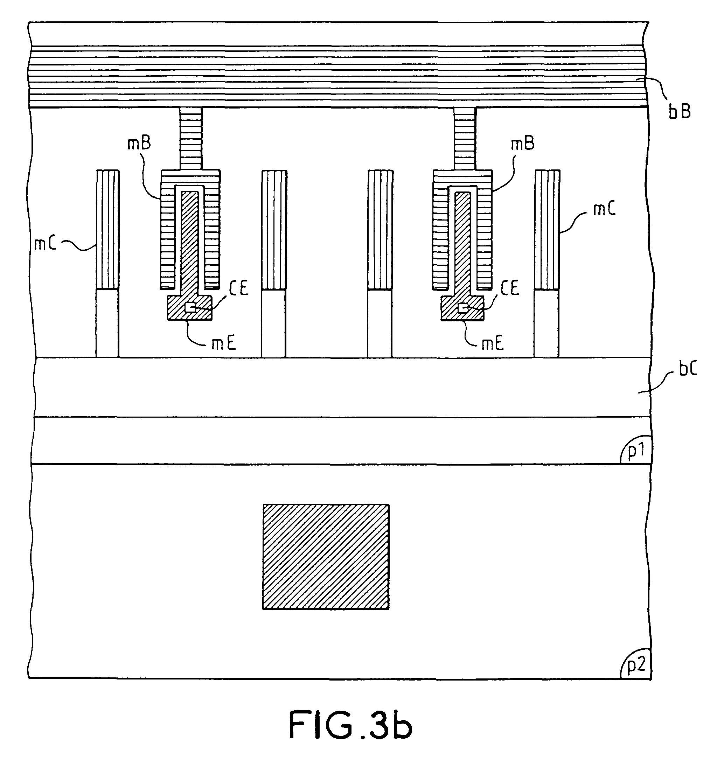

La figure 3 illustre l'association de deux transistors mis en parallèle. Dans les composants classiques on peut typiquement associer jusqu'à au moins quatre transistors en parallèle.

Il apparaît sur la figure 3a, la partie aérienne PI du dissipateur thermique, se présentant sous forme de pont, dont les jambes reposent sur les mésa, émetteur/base. La prise de contact émetteur CE est assurée de manière classique à une extrémité du doigt émetteur.

La figure 3b montre une vue de dessus des deux transistors associés et met en évidence le bus de base bB et le bus collecteur bC qui permettent de prendre latéralement les contacts au niveau des bases et des collecteurs. Les points CE₁ et CE₂ sont relatifs aux contacts électriques pris au niveau des émetteurs des transistors.

Cette vue de dessus est coupée au niveau des métallisations d'émetteur mE selon un premier plan p₁ et coupée au niveau de la face avant du substrat selon un second plan p₂.

La première partie du dissipateur thermique recouvre le plan p₁, la seconde partie du drain thermique recouvre le plan p₂.

Dans l'exemple de composant décrit en figure 3, un via-trou est représenté au niveau du plan p₂ permettant de relier le dissipateur thermique avec un plan de masse situé au niveau de la face arrière du substrat.

Typiquement, la face arrière du substrat peut être métallisée par exemple avec de l'or après amincissement pour réaliser le plan de masse.

Dans une telle configuration, la mise à la masse au travers du substrat, des électrodes supérieures permet le refroidissement et l'homogénéisation de la température des transistors, l'évacuation de la chaleur dissipée s'effectuant d'une part sous le composant à travers le substrat et d'autre part via la métallisation supérieure épaisse que constitue la partie aérienne du dissipateur thermique.

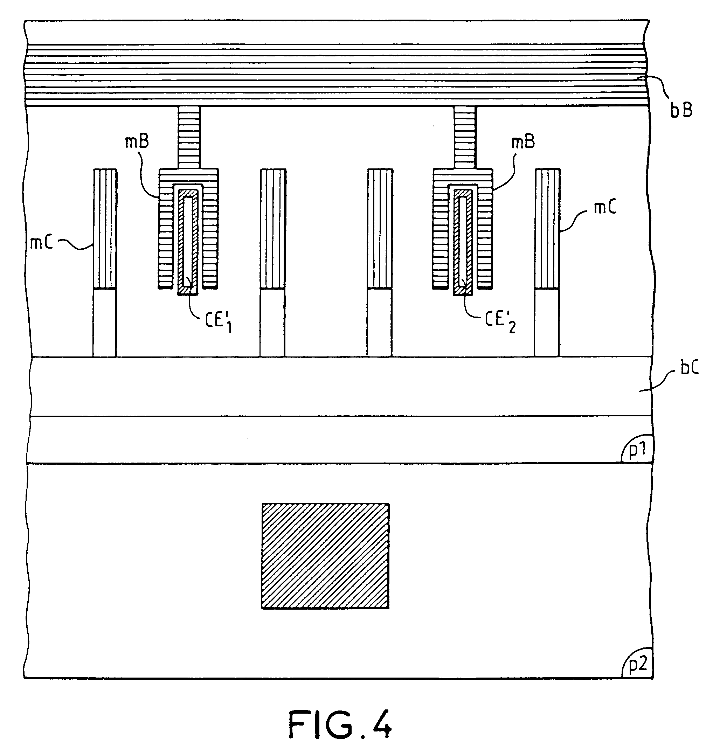

Dans une seconde variante de l'invention illustrée en figure 4, les contacts émetteurs CE'₁ et CE'₂ sont pris directement sur chacun des doigts, et donc toute une partie de la couche CP est dégagée au niveau de la métallisation d'émetteur mE.

Pour assurer un couplage thermique correct entre le dissipateur thermique et le transistor, la couche de passivation CP doit présenter une conductivité thermique suffisante. Typiquement, le matériau de la couche CP peut être choisi parmi SiN, GaN, Bn, SiC, le diamant.

Le dissipateur thermique est constitué d'un métal bon conducteur thermique, il peut notamment s'agir d'or ou de cuivre.

Pour illustrer l'intérêt que représente le dissipateur thermique ici proposé, des composants semiconducteurs comprenant des structures à plusieurs doigts élémentaires avec dissipateur thermique et sans dissipateur thermique ont été comparés.

Dans les deux types de composant, chacun des doigts présente une surface d'émetteur de 2x30 µm² avec un espacement inter-doigt de 32 µm.

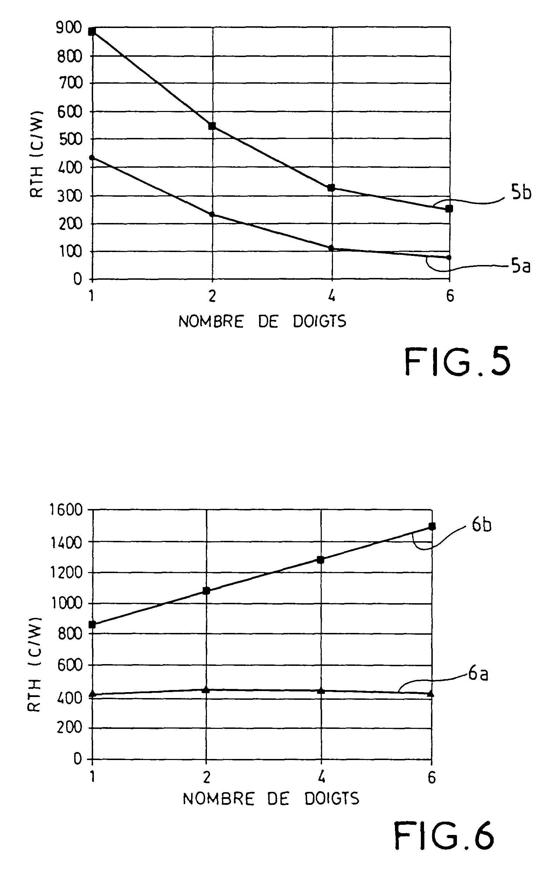

La figure 5 montre l'évolution de la résistance thermique en fonction du nombre de doigts, pour des composants avec dissipateur thermique (courbe 5a) et sans dissipateur thermique (courbe 5b).

Par ailleurs, la figure 6 illustre l'évolution de la résistance thermique de chacun des doigts dans un composant à 4 doigts avec dissipateur thermique (courbe 6a) et sans dissipateur thermique (courbe 6b).

Il ressort des figures 5 et 6 qu'une diminution importante de la résistance thermique est obtenue grâce à la présence du dissipateur thermique et qu'en l'absence de dissipateur thermique, la résistance thermique augmente linéairement avec le nombre de doigts. Cela est dû au couplage thermique entre doigts élémentaires. En revanche, en présence du dissipateur thermique, chacun des doigts apparaît découplé thermiquement de ses voisins.

Par ailleurs, la diminution de la résistance thermique améliore à la fois les performances électriques et la fiabilité du composant en diminuant sa température de fonctionnement.

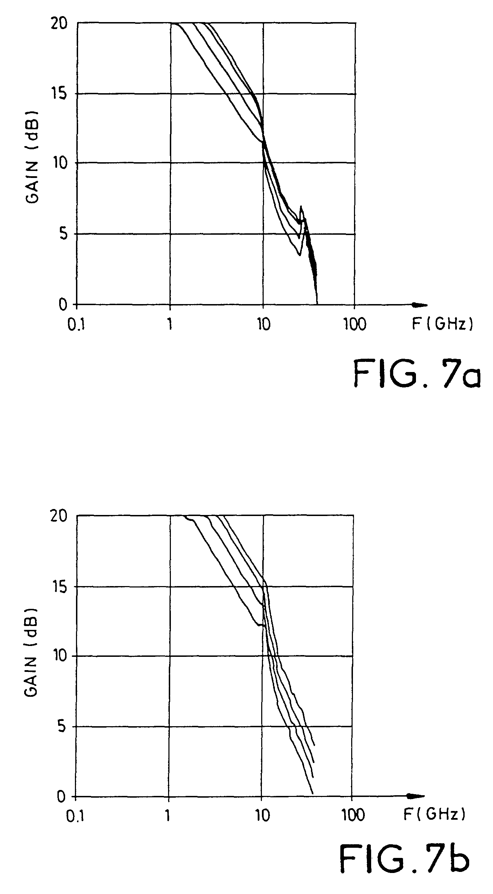

A ce titre, la figure 7 montre l'évolution du gain hyperfréquence en fonction de la fréquence, pour différents courants collecteur (de 5 mA à 40 mA) pour une tension entre émetteur et collecteur V_{CE} = 7V. La figure 7a est relative à un composant comportant une structure à deux doigts, sans dissipateur thermique. La figure 7b est relative à un composant comportant une structure à deux doigts avec dissipateur thermique. Il apparaît ainsi que le gain hyperfréquence peut être majoré de 2 dB à 10 GHz, ce qui s'avère très important pour le rendement de puissance ajoutée des dispositifs.

Nous allons décrire un exemple de procédé de réalisation de dissipateur thermique utilisé dans un composant selon l'invention, illustré en figure 3.

De manière classique on réalise à partir de couches épitaxiées sur substrat semiconducteur, la structure de "double mésa" désirée, permettant l'élaboration par exemple de transistors bipolaires.

L'ensemble du composant est recouvert d'une couche de passivation CP.

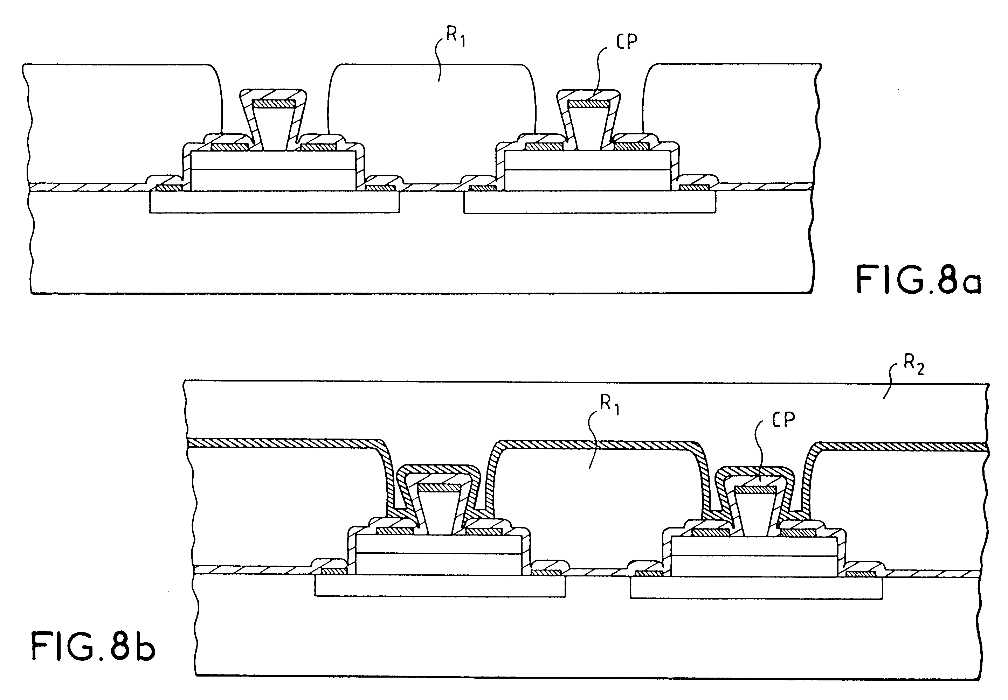

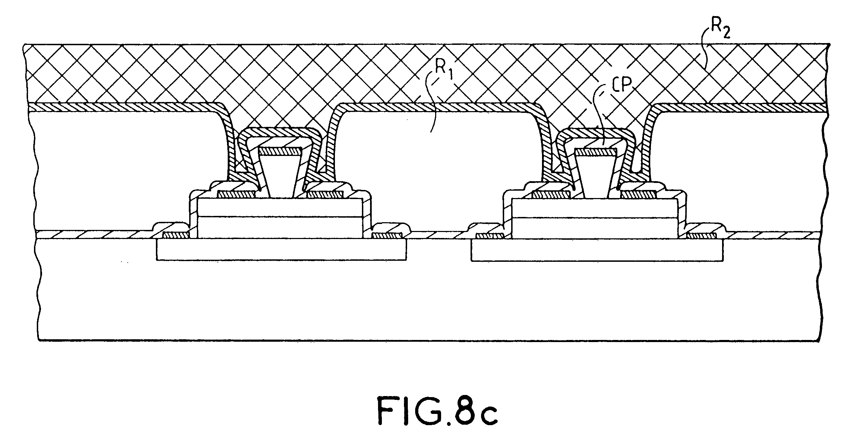

Puis on dépose sur cette couche de passivation CP une résine positive R₁, ultérieurement insolée localement de manière à dégager les zones dans lesquelles on voudra implanter le dissipateur thermique comme illustré en figure 8a (qu'il s'agisse des parties aériennes PI représentées ou des parties Pll non représentées).

L'ensemble est alors recouvert d'une fine couche métallique obtenue par évaporation. Cette fine couche métallique servira ultérieurement d'électrode pour le dépôt d'or électrolytique qui permettra la réalisation du dissipateur thermique métallique épais (figure 8b)

Au-dessus de cette fine couche métallique, on dépose une résine R₂, ultérieurement insolée là où l'on élabore le dissipateur thermique.

On procède au dépôt d'or électrolytique sur une forte épaisseur (typiquement une dizaine de microns) réalisation proprement dite du dissipateur thermique.

On pulvérise la fine couche métallique là où il n'y a pas d'or électrolytique.

On retire l'ensemble de la résine R₁, de manière à faire apparaître la partie aérienne PI du dissipateur thermique.

## Revendications

1. Dispositif semiconducteur comprenant au moins une région comportant un premier mesa sur une première face du substrat dite face avant et un second mesa formé sur le premier mesa, ladite région étant la source d'un important dégagement de chaleur, les mesas et la face avant étant recouverts d'une couche de passivation (CP), le dispositif comprenant un dissipateur thermique métallique comportant :
- une partie aérienne (PI) se présentant sous forme de pont dont les jambes reposent sur la couche (CP) située sur l'ensemble du premier et du deuxième mesa, la partie aérienne (PI) ayant des parties qui s'étendent au-dessus de régions de la face avant autres que celles constituant le premier et le deuxième mesa sans toucher ces régions ;
- une partie (Pll) recouvrant des régions de la face avant du substrat, autres que celles constituant le premier et le deuxième mesa, et autres que lesdites régions au-dessus desquelles la partie aérienne (PI) a des parties qui s'étendent.

2. Dispositif semiconducteur selon la revendication 1, **caractérisé en ce qu'**il comprend un transistor ou des transistors montés en parallèle, chaque transistor présentant deux mésa successifs à partir du substrat, un premier mésa constitué par la base, un second mésa constitué par l'émetteur, le premier mésa comportant des métallisations de base (mB) de part et d'autre de l'émetteur, le second mésa comportant une métallisation d'émetteur (mE), la partie aérienne (PI) du dissipateur thermique reposant sur la couche (CP) située sur l'ensemble de la métallisation (mE) du premier mesa et sur les métallisations (mB) du deuxième mesa, les contacts d'émetteur (CE) étant déportés par rapport aux transistors.

3. Dispositif semiconducteur selon la revendication 1, **caractérisé en ce qu'**il comprend un transistor ou des transistors montés en parallèle, chaque transistor présentant deux mésa successifs à partir du substrat, un premier mésa constitué par la base, un second mésa constitué par l'émetteur, le premier mésa comportant des métallisations de base (mB) de part et d'autre de l'émetteur, le second mésa comportant une métallisation d'émetteur (mE), la partie aérienne (PI) du dissipateur thermique reposant au niveau de l'ensemble métallisation (mE)/métallisation (mB), partiellement sur la couche (CP) et partiellement sur la métallisation (mE), les contacts émetteurs (CE') étant pris directement sur les transistors.

4. Dispositif semiconducteur selon l'une des revendications 1 à 3, **caractérisé en ce que** la partie (Pll) est reliée à la face arrière du substrat par l'intermédiaire de via-trous au travers du substrat, ladite face arrière présentant un plan de masse métallique.

5. Dispositif semiconducteur selon la revendication 2, **caractérisé en ce que** les transistors sont des transistors bipolaires à hétérojonction de type GalnP/GaAs.

6. Dispositif semiconducteur selon l'une des revendications 1 à 5, **caractérisé en ce que** la couche de passivation (CP) est de type SiN, GaN, BN, SiC.

7. Dispositif semiconducteur selon l'une des revendications 1 à 6, **caractérisé en ce que** le dissipateur thermique est en métal bon conducteur thermique de type or, cuivre.

8. Dispositif semiconducteur selon la revendication 7, **caractérisé en ce que** l'épaisseur du dissipateur thermique est voisine d'une dizaine de microns.

## Patentansprüche

1. Halbleitervorrichtung mit mindestens einer Zone, die eine erste Mesa-Struktur auf einer ersten Seite eines Substrats, Vorderseite genannt, und eine zweite Mesa-Struktur auf der ersten Mesa-Struktur besitzt, wobei diese Zone im Betrieb erhebliche Wärme entwickelt und die Mesastrukturen und die Vorderseite mit einer Passivierungsschicht (CP) bedeckt sind, wobei weiter die Vorrichtung einen Metallkühler besitzt, der enthält:
- einen der Luft ausgesetzten Bereich (PI) in Form einer Brücke, deren Pfeiler auf der Schicht (CP) ruhen, die die erste und die zweite Mesa-Struktur bedeckt, wobei der der Luft ausgesetzte Bereich (PI) Teilbereiche enthält, die sich oberhalb von anderen Zonen der Vorderseite als denen erstrecken, die die erste und die zweite Mesa-Struktur bilden, ohne diese Zonen zu berühren;
- einen Bereich (PII), der andere Zonen der Vorderseite des Substrats bedeckt als die, welche die erste und zweite Mesa-Struktur bilden, sowie die, welche die Zonen bilden, oberhalb von denen der der Luft ausgesetzte Bereich (PI) sich erstreckende Bereiche besitzt.

2. Halbleitervorrichtung nach Anspruch 1, **dadurch gekennzeichnet, daß** sie einen Transistor oder parallelgeschaltete Transistoren besitzt, wobei jeder Transistor zwei aufeinanderfolgende Mesa-Strukturen ausgehend vom Substrat besitzt, nämlich eine erste von der Basis gebildete Mesa-Struktur und eine zweite vom Emitter gebildete Mesa-Struktur, wobei die erste Mesa-Struktur Basis-Metallbeschichtungen (mB) zu beiden Seiten des Emitters besitzt, während die zweite Mesa-Struktur eine Emitter- Metallbeschichtung (mE) besitzt, und wobei der der Luft ausgesetzte Bereich (PI) des Kühlers auf der Schicht (CP) ruht, die sich sowohl über die Metallbeschichtung (mE) der ersten Mesa-Struktur als auch über die Metallbeschichtungen (mB) der zweiten Mesa-Struktur befindet, während die Emitterkontakte (CE) bezüglich der Transistoren versetzt sind.

3. Halbleitervorrichtung nach Anspruch 1, **dadurch gekennzeichnet, daß** sie einen Transistor oder parallelgeschaltete Transistoren besitzt, wobei jeder Transistor zwei aufeinanderfolgende Mesa-Strukturen ausgehend vom Substrat besitzt, nämlich eine erste von der Basis gebildete Mesa-Struktur und eine zweite vom Emitter gebildete Mesa-Struktur, wobei die erste Mesastruktur Basis-Metallbeschichtungen (mB) zu beiden Seiten des Emitters besitzt, während die zweite Mesa-Struktur eine Emitter-Metallbeschichtung (mE) besitzt, und wobei der der Luft ausgesetzte Bereich (PI) des Kühlers in Höhe der gemeinsamen Metallbeschichtung (mE/mB) teilweise auf der Schicht (CP) und teilweise auf der Metallbeschichtung (mE) ruht, sodaß die Emitterkontakte (CE') unmittelbar auf den Transistoren liegen.

4. Vorrichtung nach einem der Ansprüche 1 bis 3, **dadurch gekennzeichnet, daß** der Bereich (PII) an die Rückseite des Substrats über das Substrat durchdringende Löcher angeschlossen ist und daß die Rückseite eine metallische Masse-Ebene besitzt.

5. Halbleitervorrichtung nach Anspruch 2, **dadurch gekennzeichnet, daß** die Transistoren bipolare Transistoren mit Heterojunktion vom Typ GaInP/GaAs sind.

6. Halbleitervorrichtung nach einem der Ansprüche 1 bis 5, **dadurch gekennzeichnet, daß** die Passivierungsschicht (CP) aus SiN, GaN, BN, SiC besteht.

7. Halbleitervorrichtung nach einem der Ansprüche 1 bis 6, **dadurch gekennzeichnet, daß** der Kühler aus einem gut wärmeleitenden Metall wie Gold oder Kupfer ist.

8. Halbleitervorrichtung nach Anspruch 7, **dadurch gekennzeichnet, daß** die Dicke des Kühlers bei etwa 10 µm liegt.

## Claims

1. Semiconductor device comprising at least one region having a first mesa on a first face of the substrate, called the front face, and a second mesa formed on the first mesa, the said region being the source of a considerable devolution of heat, both the front face and the mesas being covered with a passivation layer (CP), the device comprising a metal heat sink having:
- an overhead part (P_{I}) in the form of a bridge whose legs rest on the layer (CP) lying over the entire first and second mesas, the overhead part (P_{I}) having parts which extend above regions of the front face other than those constituting the first and second mesas without touching these regions;
- a part (P_{II}) covering regions of the front face of the substrate other than those constituting the first and second mesas and other than the said regions above which the overhead part (P_{I}) has parts which extend.

2. Semiconductor device according to Claim 1, **characterized in that** it comprises a transistor or parallel-connected transistors, each transistor having two successive mesas starting from the substrate, a first mesa formed by the base and a second mesa formed by the emitter, the first mesa having base metallizations (m_{B}) on each side of the emitter, the second mesa having an emitter metallization (m_{E}), the overhead part (P_{I}) of the heat sink resting on the layer (CP) located over the entire metallization (m_{E}) of the first mesa and over the metallizations (m_{B}) of the second mesa, the emitter contacts (C_{E}) being offset with respect to the transistors.

3. Semiconductor device according to Claim 1, **characterized in that** it comprises a transistor or parallel-connected transistors, each transistor having two successive mesas starting from the substrate, a first mesa formed by the base and a second mesa formed by the emitter, the first mesa having base metallizations (m_{B}) on each side of the emitter, the second mesa having an emitter metallization (m_{E}), the overhead part (P_{I}) of the heat sink resting on the metallization (m_{E})/metallization (m_{B}) assembly, partly on the layer (CP) and partly on the metallization (m_{E}), the emitter contacts (C_{E'}) being taken directly onto the transistors.

4. Semiconductor device according to any one of Claims 1 to 3, **characterized in that** the part (P_{II}) is connected to the rear face of the substrate by means of via-holes through the substrate, the said rear face having a metal earth plane.

5. Semiconductor device according to Claim 2, **characterized in that** the transistors are heterojunction bipolar transistors of the GaInP/GsAs type.

6. Semiconductor device according to one of Claims 1 to 5, **characterized in that** the passivation layer (CP)is of the SiN, GaN, BN, SiC type.

7. Semiconductor device according to one of Claims 1 to 6, **characterized in that** the heat sink is made of a metal which is a good heat conductor, of the gold or copper type.

8. Semiconductor device according to Claim 7, **characterized in that** the thickness of the heat sink is around ten microns.
